# EUROPEAN PATENT APPLICATION

(11) **EP 4 679 976 A1**
(43) Date of publication of application: **14.01.2026**
(21) Application number: 25736593.2
(22) Date of filing: 16.04.2025
(51) Int. Cl.: H10F 10/14

(54) **BATTERY CELL, BATTERY STRING, AND PHOTOVOLTAIC MODULE**

(30) Priority: 08.05.2024 CN 202410565455
(71) Applicant: LONGi Green Energy Technology Co., Ltd., Xi'an, Shaanxi 710100 (CN)
(72) Inventor: LIN, Hua, Xi'an, Shaanxi 710100 (CN); ZHANG, Liang, Xi'an, Shaanxi 710100 (CN); WANG, Weide, Xi'an, Shaanxi 710100 (CN); FENG, Chunnuan, Xi'an, Shaanxi 710100 (CN); LYU, Yuan, Xi'an, Shaanxi 710100 (CN)
(74) Representative: Grünecker Patent- und Rechtsanwälte PartG mbB
(86) International application number: PCT/CN2025/089342
(87) International publication number: WO 2025/232489

(57) **Abstract**

The present application provides a solar cell, a solar cell string, and a photovoltaic module. The solar cell includes a first doped region and a second doped region disposed on one surface of a substrate, where each of the first doped region and the second doped region includes a main part disposed along a first direction and finger-shaped parts connected to the main part, the main part of the first doped region is a first main part, the main part of the second doped region is a second main part, the finger-shaped parts of the first doped region are first finger-shaped parts, the finger-shaped parts of the second doped region are second finger-shaped parts, the first finger-shaped parts and the second finger-shaped parts are interdigitally arranged along the first direction, and an insulation layer is disposed at a position on the first finger-shaped part close to the second main part; and the insulation layer covers at least an end portion of the first finger-shaped part close to the second main part and extends to a gap region between the first finger-shaped part and the second main part. The solar cell string includes at least two solar cells and an electrical connection member, where the electrical connection member is joined to the at least two solar cells by using a joining layer. The photovoltaic module includes at least one solar cell string.

## Description

### TECHNICAL FIELD

At least one embodiment of the present application relates to the field of photovoltaic technologies, and in particular, to a solar cell, a solar cell string, and a photovoltaic module.

### BACKGROUND

In a back contact solar cell, electrodes are arranged on different doped regions on a back face of the solar cell to form a positive electrode and a negative electrode.

A doped region includes a main part and a finger-shaped part connected to the main part. A main grid is appropriately configured on the main part, and a sub-grid connected to the main grid is appropriately configured on the finger-shaped part. To prevent a main grid and a sub-grid of different polarities on different doped regions from being electrically connected to each other, an insulation layer needs to be disposed on the sub-grid of a different polarity adjacent to the main grid.

Currently, an insulation layer covers only an end portion of a sub-grid, and a gap exists between an end portion of the insulation layer close to a main part of another doped region and the main part. Under an effect of a strong electric field, electric leakage is caused for the insulation layer located in the gap, and consequently conversion efficiency of the solar cell is reduced.

### SUMMARY

To resolve at least one technical problem in this and other aspects of the related art, the present application provides a solar cell, a solar cell string, and a photovoltaic module. An insulation layer covers a gap region between a first finger-shaped part of a first doped region and a second main part of a second doped region, so that there is no gap between the gap region and the main part, thereby preventing occurrence of an electric leakage situation.

An embodiment of the present application provides a solar cell, including a first doped region and a second doped region disposed on one surface of a substrate, where each of the first doped region and the second doped region includes a main part disposed along a first direction and finger-shaped parts connected to the main part, the main part of the first doped region is a first main part, the main part of the second doped region is a second main part, the finger-shaped parts of the first doped region are first finger-shaped parts, the finger-shaped parts of the second doped region are second finger-shaped parts, the first finger-shaped parts and the second finger-shaped parts are interdigitally arranged along the first direction, and an insulation layer is disposed at a position on the first finger-shaped part close to the second main part; and the insulation layer covers at least an end portion of the first finger-shaped part close to the second main part and extends to a gap region between the first finger-shaped part and the second main part.

According to an embodiment of the present application, the second main part protrudes from a surface of the substrate or is located in the substrate, and the first finger-shaped part protrudes from the surface of the substrate or is located in the substrate; and in an orthographic projection along a thickness direction of the substrate, the gap region is formed between an end portion of the second main part close to the first finger-shaped part and the end portion of the first finger-shaped part close to the second main part.

According to an embodiment of the present application, the solar cell further a first sub-grid disposed on the first finger-shaped part and electrically connected to the first finger-shaped part, where the insulation layer covers an end portion of the first sub-grid close to the second main part.

According to an embodiment of the present application, the insulation layer extends from the gap region to the second main part.

According to an embodiment of the present application, a thickness of a portion of the insulation layer located on the gap region is greater than a thickness of a portion of the insulation layer located on the second main part.

According to an embodiment of the present application, the first doped region and the second doped region protrude from the surface of the substrate, and in the thickness direction of the substrate, the first doped region and the second doped region have different heights.

According to an embodiment of the present application, the solar cell further a passivation layer, where the passivation layer covers the gap region, and the insulation layer covers the passivation layer in the gap region.

According to an embodiment of the present application, the first doped region and/or the second doped region includes at least one of an in-situ doped region, polysilicon, amorphous silicon, and microcrystalline silicon.

According to an embodiment of the present application, one of the first doped region and the second doped region is an N-type doped region, and the other is a P-type doped region.

According to an embodiment of the present application, for at least one part of the first doped region and the second doped region, finger-shaped parts of the at least one part are formed on a side of a main part of the at least one part, and extend along a second direction intersecting with the first direction.

According to an embodiment of the present application, for at least one part of the first doped region and the second doped region, finger-shaped parts of the at least one part are formed on two sides of a main part of the at least one part, and extend along a second direction intersecting with the first direction.

An embodiment of the present application further provides a solar cell string, including at least two solar cells and an electrical connection member, where the electrical connection member is joined to the at least two solar cells by using a joining layer.

According to an embodiment of the present application, the joining layer is disposed on the second main part of the solar cell, and the joining layer overlaps with the insulation layer.

An embodiment of the present application further provides a photovoltaic module, including at least one solar cell string.

According to the solar cell, the solar cell string, and the photovoltaic module provided in the present application, the insulation layer covers the gap region between the first finger-shaped part and the second main part, which is properly used for preventing the joining layer used for soldering from entering the gap region, so as to prevent electric leakage caused by a large electric field strength being formed between a portion of the joining layer in the gap region and an electrode.

### BRIEF DESCRIPTION OF THE DRAWINGS

FIG. 1 is a schematic diagram of a partial top-view of a solar cell according to an exemplary embodiment of the present application;
FIG. 2 is a partial enlarged view of a first finger-shaped part in the exemplary embodiment shown in FIG. 1;
FIG. 3 is a partial cross-sectional view of a portion A1 and a portion A2 of the schematic embodiment shown in FIG. 2, and shows an embodiment of a hybrid back contact solar cell; and
FIG. 4 is a partial cross-sectional view of a solar cell according to another exemplary embodiment, and shows an embodiment of a TBC solar cell.

In the accompanying drawings, specific meanings of reference numerals are as follows:
1-insulation layer;
2-first main grid;
3-first sub-grid;
4-second main grid;
5-second sub-grid;
6-first doped region;
   601-first main part;
   602-first finger-shaped part;
7-second doped region;
   701-second main part;
   702-second finger-shaped part;
8-substrate;
9-passivation layer; and
10-interface layer.

### DETAILED DESCRIPTION

To make the objectives, technical solutions, and advantages of the present application more comprehensible, the present application is further described below in detail with reference to specific embodiments and the accompanying drawings.

The terms used herein are intended only to describe specific embodiments and are not intended to limit the present application. The terms "include", "include", and the like used herein indicate the presence of features, steps, operations, and/or components, but do not preclude the presence or addition of one or more other features, steps, operations, or components.

All terms including technical and scientific terms used herein have the ordinary meanings as understood by a person of skilled in the art, unless defined otherwise. It should be noted that the terms used herein should be interpreted as having meanings consistent with the context of this specification and should not be interpreted in an idealized or excessively stereotyped manner.

A person skilled in the art will understand that elements in the accompanying drawings are illustrated for simplicity and clarity, and are not necessarily drawn to scale. For example, the sizes of some elements in the accompanying drawings may be exaggerated relative to other elements, to help improve understanding of the embodiments of the present application.

When an expression similar to "at least one of A, B, and C" is used, the expression should be generally explained according to a meaning of the expression that a person skilled in the art usually understands. For example, "a system having at least one of A, B, and C" should include but is not limited to a system having only A, only B, only C, A and B, A and C, B and C, and/or A, B, and C, and the like. When an expression similar to "at least one of A, B, or C" is used, the expression should be generally explained according to a meaning of the expression that a person skilled in the art usually understands. For example, "a system having at least one of A, B, or C" should include but is not limited to a system having only A, only B, only C, A and B, A and C, B and C, and/or A, B, and C, and the like.

A back face of a back contact solar cell (that is, a BC solar cell) is provided with a first doped region and a second doped region. Each of the first doped region and the second doped region includes a main part and a finger-shaped parts. A main grid electrically connected to the main part is appropriately disposed on the main part, and a sub-grid electrically connected to the main grid of a same polarity is appropriately disposed on the finger-shaped part, so that a positive electrode and a negative electrode are respectively formed on different doped regions. To insulate the main grid from the sub-grid of a different polarity, an insulation layer needs to be disposed at an end portion of the sub-grid of the different polarity adjacent to the main grid, to avoid occurrence of a short circuit problem caused by connection between the main grid and the sub-grid of the different polarity.

Currently, the disposed insulation layer covers only the end portion of the sub-grid, but does not cover the gap region between the first finger-shaped part of the first doped region and the second main part of the second doped region. There is a gap between the end portion, close to the second main part, of the insulation layer located in the gap region and the second main part. In a manufacturing process of the solar cell, a joining layer (for example, a solder, including but not limited to soldering tin) easily spreads and is embedded in the gap, so that a large electric field strength is formed between the joining layer and the sub-grid after soldering is completed. The excessive electric field strength causes electric charges to leak from a weak region (for example, a thin part) of the insulation layer to cause electric leakage, thereby affecting conversion efficiency of the solar cell.

In view of this, how to provide a solar cell, a solar cell string, and a photovoltaic module that can effectively improve an insulation property of an insulation layer and prevent electric leakage becomes a technical problem to be urgently resolved.

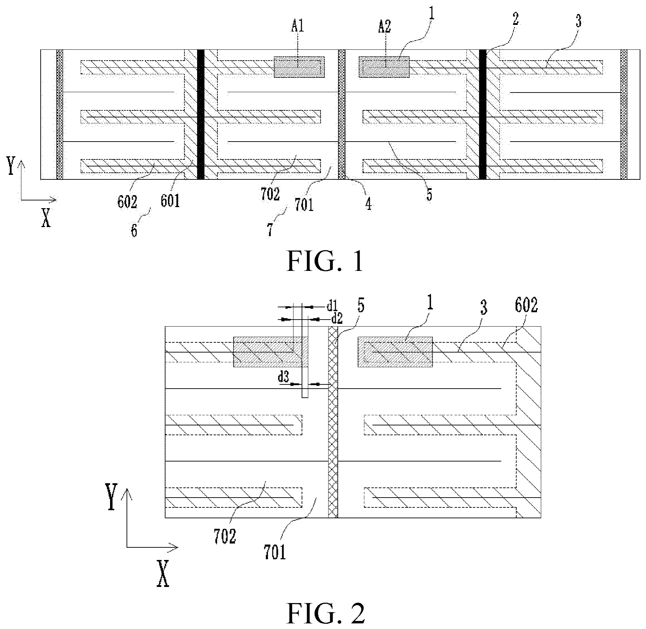

FIG. 1 is a schematic diagram of a partial top-view of a solar cell according to an exemplary embodiment of the present application.

The solar cell provided according to the present application, as shown in FIG. 1, includes a first doped region 6 and a second doped region 7 that are disposed on one surface of a substrate 8, and each of the first doped region 6 and the second doped region 7 includes a main part disposed along a first direction and finger-shaped parts connected to the main part. The finger-shaped parts of the first doped region 6 and the finger-shaped parts of the second doped region 7 are interdigitally arranged along the first direction, and an insulation layer 1 is disposed at a position on the first finger-shaped part 602 of the first doped region 6 close to the second main part 701 of the second doped region 7. The insulation layer 1 covers at least an end portion of the first finger-shaped part 602 close to the second main part 701 (for example, a right end of the first finger-shaped part 602 covered by A1, and a left end of the first finger-shaped part covered by A2) and extends to a gap region between the first finger-shaped part 602 and the second main part 701. In an exemplary embodiment, as shown in FIG. 1, one surface (a surface facing a viewing angle shown in FIG. 1, where the substrate is shaded by the first doped region 6 and the second doped region 7, and is not shown) of the substrate 8 is provided with the first doped region 6 and the second doped region 7. Specifically, the first doped region 6 includes a first main part 601 and first finger-shaped parts 602. The second doped region 7 includes a second main part 701 and second finger-shaped parts 702. The first main part 601 and the second main part 701 both extend along the first direction (the direction Y shown in FIG. 1). The first finger-shaped parts 602 and the second finger-shaped parts 702 extend from the main part (that is, the first main part 601 or the second main part 701) along the second direction (the direction X shown in FIG. 1) to a side (the left side and/or the right side shown in FIG. 1) away from the main part, to form an interdigital arrangement. Further, the first finger-shaped parts 602 of the first doped region 6 and the second finger-shaped parts 702 of the second doped region 7 have a concave-convex structure relative to each other in the first direction (the direction Y shown in FIG. 1), and are sequentially alternately arranged at intervals along the first direction.

A first main grid 2 and a first sub-grid 3 are disposed on the first doped region 6. The first main grid 2 is disposed on the first main part 601 along the first direction (an up-down direction shown in FIG. 1), the first sub-grid 3 is disposed on the first finger-shaped part 602 along the second direction (a left-right direction shown in FIG. 1), and the first sub-grid 3 is in physical and electrical contact with the first main grid 2. In addition, the first main grid 2 is connected to a plurality of first sub-grids 3, and the first main grid 2 is used for collecting current aggregated by the plurality of first sub-grids 3 (that is, fine grids). In addition, a joint (for example, a pad) may be further disposed on the first doped region 6, and one side of the joint connects at least two first sub-grids 3. The joint may be connected to the first main grid 2, or may not be connected to the first main grid 2.

A second main grid 4 and a second sub-grid 5 are disposed on the second doped region 7. The second main grid 4 is disposed on the second main part 701 along the first direction (the up-down direction shown in FIG. 1), the second sub-grid 5 is disposed on the second finger-shaped part 702 along the second direction (the left-right direction shown in FIG. 1), and the second sub-grid 5 is in physical and electrical contact with the second main grid 4. In addition, the second main grid 4 is connected to a plurality of second sub-grids 5, and the second main grid 4 is used for collecting current aggregated by the plurality of second sub-grids 5 (that is, fine grids). In addition, a joint (for example, a pad) may be further disposed on the second doped region 4, and one side of the joint connects at least two second sub-grids 5. The joint may be connected to the second main grid 4, or may not be connected to the second main grid 4.

It should be understood that the main part is not necessarily continuous along the first direction, and may extend from one side to the other opposite side in the first direction, or may be intermittently disposed between two sides disposed opposite to each other in the first direction. However, in some embodiments, the main part may be one section or two sections. When the main part is one section, the section is close to one of the two sides disposed opposite to each other in the first direction. When the main part is two sections, the two sections are respectively disposed on two sides that are disposed opposite to each other in the first direction. A main grid (including the first main grid 2 and the second main grid 4) is disposed corresponding to the main part, and may also be continuously or intermittently disposed.

When an electrical connection member (for example, a soldering tape not shown) is disposed along the main grid, the electrical connection member may easily be offset and overlap with a sub-grid of a different polarity, to cause a short circuit. Therefore, the insulation layer 1 needs to be disposed at an end portion of the sub-grid of a different polarity close to the fine grid of a same polarity, to prevent a short circuit. As shown in FIG. 1, the insulation layer 1 is disposed at an end portion of the first sub-grid 3 close to the second main grid 4. Insulation blocks A1 and A2 are provided in the figure. Only two insulation blocks are schematically provided in the figure. It should be understood that the insulation layer 1 may be disposed at an end portion of each first sub-grid 3 close to the second main grid 4.

As an embodiment of the present application, the insulation layer 1 covers the end portions of the first sub-grid 3 and the second sub-grid 5, and the insulation layer 1 extends into the gap region, and completely fills the gap region in an embodiment. The gap region is an electrical gap region between the first finger-shaped part 602 and the second main part 701, or an electrical gap region between the second finger-shaped part 702 and the first main part 601.

In an exemplary embodiment, as shown in FIG. 1, the insulation layer 1 (to make the figure clear, only two insulation layers 1 are schematically shown in FIG. 1) is disposed in a gap region (a dashed part shown in FIG. 1) between each first finger-shaped part 602 and the second main part 701. Specifically, the insulation layer 1 includes but is not limited to being configured as a rectangular structure. In addition, the insulation layer 1 includes a plurality of block structures, and each block structure corresponds to a tip position of the sub-grid. Further, the insulation layer 1 includes but is not limited to being made of an insulation adhesive (for example, green adhesive).

In such an embodiment, the gap region between the first finger-shaped part 602 and the second main part 701 is covered by the insulation layer 1. In this way, in a soldering process, because the gap region is covered by the insulation layer 1, a joining layer (including but not limited to a solder such as soldering tin) used for soldering can be effectively prevented from entering the gap region, so as to prevent an excessive electric field strength from being formed between the joining layer and an electrode (for example, the sub-grid) in the gap region, thereby avoiding occurrence of an electric leakage situation. In addition, the thick insulation layer helps to prevent the insulation layer from being punctured or broken down.

According to an embodiment of the present application, as shown in FIG. 1, for at least one part of the first doped region 6 and the second doped region 7, finger-shaped parts of the at least one part are formed on a side of a main part of the at least one part, and extend along a second direction intersecting with the first direction. For example, the at least one part is some finger-shaped parts on the leftmost side and the rightmost side in FIG. 1 and main parts corresponding to the finger-shaped parts.

In an exemplary embodiment, as shown in FIG. 1, the second doped region 7 is disposed at an edge of the substrate (for example, disposed at a left side and a right side of the substrate shown in FIG. 1). Specifically, a second finger-shaped part 702 is disposed on a side (for example, a right side of a first doped region at a left end of the substrate, and a left side of a first doped region at a right end), close to the first doped region 6, of a second main part 701 of the second doped region 7 located at an edge of the substrate. Further, a plurality of second finger-shaped parts 702 are arranged at intervals along the first direction (the direction Y shown in FIG. 1).

According to an embodiment of the present application, as shown in FIG. 1, for at least one part of the first doped region 6 and the second doped region 7, finger-shaped parts of the at least one part are formed on two sides of a main part of the at least one part, and extend along a second direction intersecting with the first direction.

In an exemplary embodiment, as shown in FIG. 1, the second doped region 7 is disposed in the middle of the substrate (for example, the second doped region disposed between two first doped regions shown in FIG. 1). Specifically, a second finger-shaped part 702 is disposed on each of two sides (a left side and a right side shown in FIG. 1) of a second main part 701 of the second doped region 7 located in the middle of the substrate. Further, the second finger-shaped parts 702 located on two sides of the second main part 701 are symmetrically (bilaterally symmetrically, as shown in FIG. 1) disposed along a center line of the second main part 701. In another embodiment, a first doped region 6 may be on the leftmost side, a second doped region 7 may be on the rightmost side, and when viewed from a center line of the solar cell, doped regions on the two sides have asymmetric structures.

According to the solar cell provided in the present application, the first doped region 6 and/or the second doped region 7 includes, but is not limited to, at least one of an in-situ doped region, polysilicon, amorphous silicon, and microcrystalline silicon. According to different structures and materials of the first doped region 6 and THE second doped region 7, the solar cell may be a back contact solar cell of TopCON, HJT, or PERC or a hybrid back contact solar cell of at least two of TopCON, HJT, and PERC.

According to the solar cell provided in the present application, the first doped region 6 and THE second doped region 7 are doped regions of opposite types, where one of the first doped region 6 and the second doped region 7 is an N-type doped region, and the other is a P-type doped region.

For example, a p-type doped region (that is, the first doped region 6) and an n-type doped region (that is, the second doped region 7) are disposed on a back face of the solar cell using an n-type silicon substrate as the substrate. An electrode disposed on the p-type doped region and connected to the p-type doped region is used as a positive electrode, and an electrode disposed on the n-type doped region and connected to the n-type doped region is used as a negative electrode. Similarly, the p-type doped region may alternatively be used as the second doped region 7, and the n-type doped region may alternatively be used as the first doped region 1.

FIG. 2 is a partial enlarged view of a first finger-shaped part in the exemplary embodiment shown in FIG. 1.

According to an embodiment of the present application, as shown in FIG. 2, the solar cell further a first sub-grid 3 disposed on the first finger-shaped part 602 and electrically connected to the first finger-shaped part 602. The insulation layer 1 covers an end portion of the first sub-grid 3 close to the second main part 701.

In an exemplary embodiment, as shown in FIG. 1 and FIG. 2, a first main grid 2 extending along the first direction (the direction Y shown in FIG. 1) is disposed on the first main part 601, and a first sub-grid 3 connected to the first main grid 2 is disposed on the first finger-shaped part 602. Similarly, a second main grid 4 extending along the first direction (the direction Y shown in FIG. 1) is disposed on the second main part 701, and a second sub-grid 5 connected to the second main grid 4 is disposed on the second finger-shaped part 702. Specifically, an opened part is formed between adjacent first sub-grids 3 along the second direction (the direction X shown in FIG. 1) and adjacent second sub-grids 5 along the second direction (the direction X shown in FIG. 1), to allow the second main grid 4 or the first main grid 2 of a different polarity to pass through.

In an exemplary embodiment, as shown in FIG. 2, a distance (that is, d2 shown in FIG. 2) between an end portion of the first sub-grid 3 covered by the insulation layer 1 and an edge of the insulation layer 1 close to the second main grid 4 (for example, a right edge of the insulation layer 1 located on the left in FIG. 2) is configured to be greater than a distance (that is, d1 shown in FIG. 2) between an end portion of the first sub-grid 3 covered by the insulation layer 1 and the second main part 701, where d2 includes, but is not limited to, being configured to range from 0.3 millimeters to 1.5 millimeters (that is, 0.3 mm ≤ d2 ≤ 1.5 mm), and d1 includes, but is not limited to, being configured to range from 0.1 millimeters to 0.5 millimeters (that is, 0.1 mm ≤ d1 ≤ 0.5 mm).

According to an embodiment of the present application, as shown in FIG. 2, the insulation layer 1 extends from the gap region to the second main part 701.

In an exemplary embodiment, as shown in FIG. 2, in an orthographic projection along the thickness direction of the substrate 8, a width (that is, d3 shown in FIG. 2) of a portion of the insulation layer 1 that extends onto the second main part 701 includes, but is not limited to, 100 µm to 500 µm (that is, 100 µm ≤ d3 < 500 µm).

In such an embodiment, because d2 is configured to be greater than d1, the insulation layer 1 may extend onto the second main part 701, and the insulation layer 1 crosses the gap region and extends to the second main part 701, so that the gap region located between the first finger-shaped part 602 and the second main part 701 may be completely covered. In this way, precision of a device provided with the insulation layer 1 (for example, precision of a screen mesh on which the insulation layer 1 is printed) is compensated, so as to leave a design allowance, thereby preventing a problem that the insulation layer 1 cannot completely cover the gap region due to the precision of the device.

According to an embodiment of the present application, a thickness of a portion of the insulation layer 1 located on the gap region is greater than a thickness of a portion of the insulation layer located on the second main part 701.

In an exemplary embodiment, the gap region between the second main part 701 and the first finger-shaped part 602 forms a recessed part that is recessed toward the substrate 8 relative to the second main part 701 and the first finger-shaped part 602. Therefore, in the orthographic projection along the thickness direction of the substrate 8, a thickness of a portion of the insulation layer 1 located in the gap region is greater than a thickness of a portion of the insulation layer 1 located on the doped region (that is, the first doped region 6 and the second doped region 7), and a thickness of a portion closer to the edge of the insulation layer 1 is smaller (that is, closer to the edge of the insulation layer, the insulation layer is thinner). In this way, electric leakage of the portion of the insulation layer 1 is further prevented. In addition, because the portion is thick, it is also beneficial to prevent the insulation layer 1 from being punctured by an electrode (for example, the first sub-grid 3).

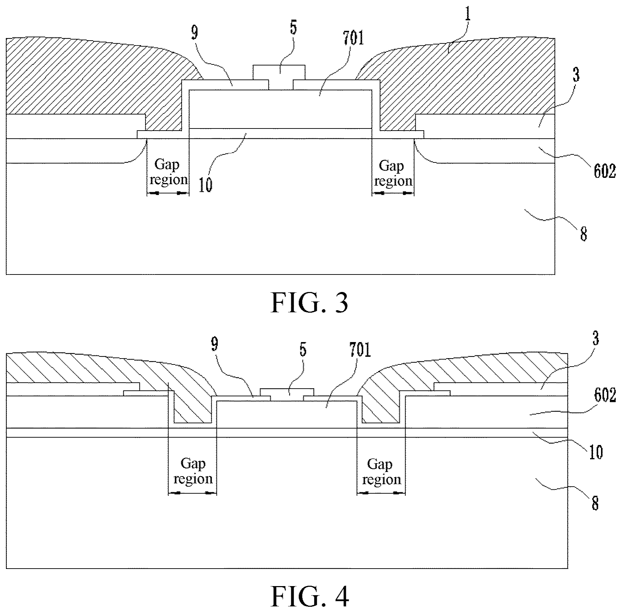

FIG. 3 is a partial cross-sectional view of a portion A1 and a portion A2 of the schematic embodiment shown in FIG. 2, and shows an embodiment of a hybrid back contact solar cell.

According to an embodiment of the present application, as shown in FIG. 1 to FIG. 3, the second main part 701 protrudes from a surface of the substrate 8 or is located in the substrate 8. The first finger-shaped part 602 protrudes from the surface of the substrate 8 or is located in the substrate 8; and in an orthographic projection along a thickness direction of the substrate 8, the gap region (that is, a gap region shown in FIG. 3) is formed between the second main part 701 and a projection of the end portion of the first finger-shaped part 602 close to the second main part 701.

In an exemplary embodiment, as shown in FIG. 3, the second main part 701 protrudes from a surface (that is, an upper surface shown in FIG. 3) of the substrate 8; and the first finger-shaped part 602 is formed in the substrate 8, and an upper surface of the first finger-shaped part 602 is configured to be approximately flush with the upper surface of the substrate 8. That is, in a thickness direction (an up-down direction shown in FIG. 3) of the substrate 8, the first doped region 6 (including the first finger-shaped part 602) is lower than the second doped region 7 (including the second main part 701). In this way, in a process of printing the insulation layer 1, an insulation material (including an insulation adhesive such as green adhesive) that is still in a liquid state cannot go so far as to excessively extend from the low first doped region 6 to an upper surface of the second doped region 7, thereby preventing the green adhesive from covering a portion of the second main grid 5. It should be understood that this embodiment of the present application is not limited thereto.

In another exemplary embodiment, not shown in the figure, the first finger-shaped part 602 is configured to protrude from the surface of the substrate 8, and the second main part 701 is located in the substrate 8. Specifically, an upper surface of the second main part 701 is configured to be approximately flush with the upper surface of the substrate 8, and a step-shaped gap region is formed between an end portion of the first finger-shaped part 602 close to the second main part 701 and the second main part 701. Further, the insulation layer 1 completely covers the gap region, and extends toward the second main part 701 to a position at which the second main grid 5 on the second main part 701 is not shaded.

In an exemplary embodiment, as shown in FIG. 3, the second main part 701 of the second doped region 7 protrudes from the upper surface of the substrate 8, and a gap region (namely, a gap region shown in FIG. 3) having a PN junction is formed between the second main part and the first finger-shaped part 602. Specifically, the second doped region 7 (including the first main part 701) includes, but is not limited to, N-type polysilicon (that is, N-POLY). Correspondingly, the first doped region 6 (including the second finger-shaped part 602) is configured as a P-type doped region that forms a PN junction with the N-type polysilicon, and the P-type doped region is an in-situ doped region. Further, a hybrid back contact solar cell (that is, a hybrid passivated back contact solar cell) having an interdigitated PN junction is formed on the back face of the solar cell by using the second finger-shaped part 702 (not shown in FIG. 3) of the second doped region 7 and the first finger-shaped part 602. Similarly, the second doped region 7 may also be P-type polysilicon (that is, P-POLY), and correspondingly, the first doped region 6 is configured as an N-type doped region.

According to an embodiment of the present application, as shown in FIG. 3, the solar cell further a passivation layer 9. The passivation layer 9 covers the gap region, and the insulation layer 1 covers the passivation layer 9 in the gap region.

In an exemplary embodiment, as shown in FIG. 3, in a cross section along the thickness direction of the substrate 8, the passivation layer 9 of the solar cell is configured as a "Z-like" cross section structure at a step at a position of the gap region, covers a surface of the gap region (that is, the gap region shown in FIG. 3), and has two ends respectively extending to the first finger-shaped part 602 and the second main part 701 that are adjacent to each other. Further, an interface layer 10 is further disposed between the second doped region 7 and the substrate 8, and the insulation layer 1 covers the passivation layer 9. The passivation layer 9 includes, but is not limited to, being made of silicon nitride, aluminum oxide, or another material that is suitable for covering the surface of the doped region and has a function of preventing the doped region from being oxidized and/or corroded. The interface layer 10 includes, but is not limited to, being made of silicon oxide, aluminum oxide, or another material suitable for lowering an interface resistance at an interface formed between the doped region and the substrate and/or reducing a recombination loss of carriers at the interface.

FIG. 4 is a partial cross-sectional view of a solar cell according to another exemplary embodiment, and shows an embodiment of a TBC solar cell.

According to an embodiment of the present application, as shown in FIG. 3, the first doped region 6 and the second doped region 7 protrude from the surface of the substrate 8, and in the thickness direction of the substrate 8, the first doped region 6 and the second doped region 7 have different heights.

In an exemplary embodiment, as shown in FIG. 4, the second main part 701 and the first finger-shaped part 602 both protrude from the surface (that is, an upper surface shown in FIG. 4) of the substrate 8, and a gap region is formed between the second main part 701 and an end portion of the first finger-shaped part 602 close to the second main part 701. Specifically, the second doped region 7 (including the first main part 701) includes, but is not limited to, N-type polysilicon (that is, N-POLY). Correspondingly, the first doped region 6 (including the second finger-shaped part 602) is configured as a P-type doped region that forms a PN junction with the N-type polysilicon. It should be understood that this embodiment of the present application is not limited thereto.

In another exemplary embodiment, not shown in the figure, the second main part 701 and the first finger-shaped part 602 are both located in the substrate 8. Specifically, upper surfaces of the second main part 701 and the first finger-shaped part 602 are approximately flush with the upper surface of the substrate 8. In an orthographic projection along the thickness direction of the substrate 8, a distance between projections of the second main part 701 and the second finger-shaped part 602 forms a gap region. Further, the second main grid 5 disposed on the second main part 701 and the first sub-grid 3 disposed on the first finger-shaped part 602 protrude from the surface of the substrate, and the insulation layer 1 covers the end portion of the first sub-grid 3 close to the second main grid 5, completely covers the gap region, and extends to a position at which the second main grid 5 is not shaded.

In an exemplary embodiment, as shown in FIG. 4, an interface layer 10 is disposed between each of the second doped region 7 (including the first main part 701) and the first doped region 6 (including the second finger-shaped part 602), and the substrate 8. The interface layer 10 may be a tunneling oxide layer, to effectively suppress recombination of interfacial carriers. Further, a passivation layer 9 is further disposed in a recessed part above the gap region between the first main part 701 and the second finger-shaped part 602. In addition, the passivation layer 9 forms a "concavity-like" cross section structure. Two ends of the passivation layer 9 extend onto the first main part 701 and the second finger-shaped part 602 respectively, that is, a TBC solar cell (that is, a tunneling back contact solar cell) is passivated based on a structure of tunneling layer + Poly layer. The insulation layer 1 covers the passivation layer 9.

Furthermore, in a thickness direction (an up-down direction shown in FIG. 4) of the substrate 8, the first doped region 6 (including the first finger-shaped part 602) is higher than the second doped region 7 (including the second main part 701). Similar to the exemplary embodiment shown in FIG. 3, in a process of printing the insulation layer 1, an insulation material (including an insulation adhesive such as green adhesive) that is still in a liquid state spreads from the surface of the first doped region 6 that is high onto the second doped region 7 that is low.

In another embodiment, the structure in FIG. 4 may be a heterojunction back contact solar cell, where the interface layer 10 is an amorphous/microcrystalline intrinsic silicon layer, and the first doped region 6 (including the first finger-shaped part 602) being higher than the second doped region 7 (including the second main part 701) may be an amorphous/microcrystalline doped silicon layer.

Based on an inventive concept the same as that of the solar cell, the present application further provides a solar cell string and a photovoltaic module.

The solar cell string provided according to the present application, which is not shown in the figure, includes at least two solar cells and an electrical connection member (for example, a soldering tape). The electrical connection member is joined to the at least two solar cells by using a joining layer.

Because an insulation layer 1 extends from one side of a finger-shaped part of a different polarity to at least reach the gap region (even reach a main part of a same polarity), a soldering tape pass-through region defined by insulation blocks (for example, A1 and A2 in FIG. 1) of two insulation layers 1 is shrunk. When the joining layer is disposed on the second main part 701 of the solar cell, at least one side of the soldering tape overlaps with the insulation layer 1, for example, overlaps with the insulation layer 1 by using the joining layer. The width of the electrical connection member is greater than the width of the main grid in an embodiment, and may range, for example, from 250 micrometers to 600 micrometers.

In an exemplary embodiment, not shown in the figure, the joining layer includes but is not limited to a solder, such as soldering tin. Specifically, the joining layer is disposed at a joining part (for example, a pad) formed by the electrical connection member (for example, a soldering tape) and an electrode of the solar cell. Further, when the joining layer is soldered, the joining layer in a liquid state includes the insulation layer 1 diffused to one side (for example, the insulation layer diffused to the left side or the right side of the second main grid 4 shown in FIG. 1), and the joining layer overlaps with the insulation layer 1 in a direction approximately parallel to a surface of the insulation layer 1. In this way, a portion of the joining layer that faces the insulation layer 1 is flat, and even when the joining layer is laminated, the insulation layer 1 is not punctured, so as to prevent a short circuit from being formed between a main grid and a sub-grid of different polarities.

The photovoltaic module provided according to the present application, not shown in the figure, includes at least one solar cell string. The at least one solar cell string is sealed by using a front encapsulation layer and a back encapsulation layer. The front encapsulation layer includes an upper adhesive film and a cover that are close to a front face of a solar cell, and the back encapsulation layer includes a lower adhesive film and a back sheet that are close to a back face of the solar cell.

It should be further noted that directional terms such as "upper", "lower", "front", "rear", "left", and "right" mentioned in the embodiments are used only for reference to the accompanying drawings, and are not intended to limit the protection scope of the present application. In the accompanying drawings, same elements are represented by same or similar reference numerals. When understanding of the present application may be confused, a conventional structure or construction is omitted.

The embodiments of the present application are described above. However, these embodiments are merely for the purpose of description, but are not intended to limit the scope of the present application. Although the embodiments are separately described above, this does not mean that the measures in the embodiments cannot be advantageously used in combination. Therefore, the scope of the present application is subject to the claims and equivalents thereof. A person skilled in the art may make various replacements and modifications without departing from the scope of the present application, and these replacements and modifications shall fall within the scope of the present application.

## Claims

1. A solar cell, comprising a first doped region (6) and a second doped region (7) disposed on one surface of a substrate (8), wherein each of the first doped region (6) and the second doped region (7) comprises a main part disposed along a first direction and finger-shaped parts connected to the main part, the main part of the first doped region (6) is a first main part (601), the main part of the second doped region (7) is a second main part (701), the finger-shaped parts of the first doped region (6) are first finger-shaped parts (602), the finger-shaped parts of the second doped region (7) are second finger-shaped parts (702), the first finger-shaped parts (602) and the second finger-shaped parts (702) are interdigitally arranged along the first direction, and an insulation layer (1) is disposed at a position on the first finger-shaped part (602) close to the second main part (701); and
the insulation layer (1) covers at least an end portion of the first finger-shaped part (602) close to the second main part (701) and extends to a gap region between the first finger-shaped part (602) and the second main part (701).

2. The solar cell according to claim 1, wherein the second main part (701) protrudes from a surface of the substrate (8) or is located in the substrate (8), and the first finger-shaped part (602) protrudes from the surface of the substrate (8) or is located in the substrate (8); and in an orthographic projection along a thickness direction of the substrate (8), the gap region is formed between the second main part (701) and a projection of the end portion of the first finger-shaped part (602) close to the second main part (701).

3. The solar cell according to claim 1, further comprising a first sub-grid (3) disposed on the first finger-shaped part (602) and electrically connected to the first finger-shaped part (602), wherein the insulation layer (1) covers an end portion of the first sub-grid (3) close to the second main part (701).

4. The solar cell according to any one of claims 1 to 3, wherein the insulation layer (1) extends from the gap region to the second main part (701).

5. The solar cell according to claim 4, wherein a thickness of a portion of the insulation layer (1) located on the gap region is greater than a thickness of a portion of the insulation layer located on the second main part (701).

6. The solar cell according to any one of claims 1 to 3, wherein the first doped region (6) and the second doped region (7) protrude from the surface of the substrate (8), and in the thickness direction of the substrate (8), the first doped region (6) and the second doped region (7) have different heights.

7. The solar cell according to any one of claims 1 to 3, further comprising a passivation layer (9), wherein the passivation layer (9) covers the gap region, and the insulation layer (1) covers the passivation layer (9) in the gap region.

8. The solar cell according to any one of claims 1 to 3, wherein the first doped region (6) and/or the second doped region (7) comprises at least one of an in-situ doped region, polysilicon, amorphous silicon, and microcrystalline silicon.

9. The solar cell according to any one of claims 1 to 3, wherein one of the first doped region (6) and the second doped region (7) is an N-type doped region, and the other is a P-type doped region.

10. The solar cell according to any one of claims 1 to 3, wherein for at least one part of the first doped region (6) and the second doped region (7), finger-shaped parts of the at least one part are formed on a side of a main part of the at least one part, and extend along a second direction intersecting with the first direction.

11. The solar cell according to any one of claims 1 to 3, wherein for at least one part of the first doped region (6) and the second doped region (7), finger-shaped parts of the at least one part are formed on two sides of a main part of the at least one part, and extend along a second direction intersecting with the first direction.

12. A solar cell string, comprising at least two solar cells according to any one of claims 1 to 11 and an electrical connection member, wherein the electrical connection member is joined to the at least two solar cells by using a joining layer.

13. The solar cell string according to claim 12, wherein the joining layer is disposed on the second main part (701) of the solar cell, and the joining layer overlaps with the insulation layer (1).

14. A photovoltaic module, comprising at least one solar cell string according to claim 12 or 13.
